# EUROPÄISCHE PATENTSCHRIFT

(11) **EP 1 716 455 B1**
(45) Veröffentlichungstag und Bekanntmachung des Hinweises auf die Patenterteilung: **11.05.2011**
(21) Anmeldenummer: 05701282.5
(22) Anmeldetag: 01.02.2005
(51) Int. Cl.: G03F 7/20

(54) **PROJEKTIONSOBJEKTIV EINER MIKROLITHOGRAPHISCHEN PROJEKTIONSBELICHTUNGSANLAGE**
PROJECTION LENS OF A MICROLITHOGRAPHIC PROJECTION EXPOSURE SYSTEM
OBJECTIF DE PROJECTION D'UN SYSTEME D'ECLAIRAGE DE PROJECTION MICROLITHOGRAPHIQUE

(30) Priorität: 20.02.2004 DE 102004008285
(43) Veröffentlichungstag der Anmeldung: 02.11.2006
(73) Patentinhaber: Carl Zeiss SMT GmbH, 73447 Oberkochen (DE)
(72) Erfinder: FISCHER, Jürgen, 89518 Heidenheim (DE)
(74) Vertreter: Schwanhäusser, Gernot
(86) Internationale Anmeldenummer: PCT/EP2005/000947
(87) Internationale Veröffentlichungsnummer: WO 2005/091077

(56) Entgegenhaltungen:
- DE-A1- 19 859 634
- US-A1- 2002 089 734
- US-B1- 6 398 373

## Beschreibung

### HINTERGRUND DER ERFINDUNG

### 1. Gebiet der Erfindung

Die Erfindung betrifft ein Projektionsobjektiv für mikrolithographische Projektionsbelichtungsanlagen, wie sie zur Herstellung hochintegrierter elektrischer Schaltkreise und anderer mikrostrukturierter Bauteile verwendet werden. Die Erfindung betrifft insbesondere Projektionsobjektive, bei denen mindestens ein optisches Element mit Hilfe eines Aktuators deformiert werden kann. Gegenstand der Erfindung ist außerdem ein Verfahren zur Korrektur optischer Eigenschaften eines solchen Projektionsobjektivs.

### 2. Beschreibung des Standes der Technik

In mikrolithographischen Projektionsbelichtungsanlagen haben Projektionsobjektive die Aufgabe, in einer Maske enthaltene Strukturen verkleinert auf eine lichtempfindliche Schicht abzubilden, die auf einem Träger aufgebracht ist. Aufgrund der geringen Größe der abzubildenden Strukturen werden an die Abbildungseigenschaften der Projektionsobjektive sehr hohe Anforderungen gestellt.

Aus der US 6 388 823 der Anmelderin ist ein Projektionsobjektiv bekannt, bei dem mit Hilfe von Aktuatoren, die um den Umfang eines optischen Elements herum erteilt sind, Kräfte auf das optische Element ausgeübt werden können. Diese Kräfte führen zu Verbiegungen des optischen Elements, bei dem es sich z.B. um eine Linse oder einen Spiegel handeln kann. Das Dickenprofil des optischen Elements wird durch die Verbiegung nicht oder zumindest nicht wesentlich beeinflußt. Mit einem derart verbiegbaren optischen Element lassen sich insbesondere astigmatische Abbildungsfehler korrigieren.

Es hat sich allerdings gezeigt, daß mit der Verbiegung nicht nur die gewünschte Korrekturwirkung einhergeht, sondern es auch zu unerwünschten Beeinträchtigungen der Abbildungseigenschaften des Projektionsobjektivs kommen kann. Dies gilt insbesondere für optische Elemente, die isostatisch gelagert sind. Eine isostatische Lagerung zeichnet sich dadurch aus, daß das optische Element lediglich an drei um 120° entlang des Umfangs versetzten Lagerungspunkten gehalten ist.

Derartige unerwünschte Beeinträchtigungen der Abbildungseigenschaften können jedoch auch durch optische Elemente verursacht werden, die zur Korrektur von Abbildungsfehlern nicht verbogen, sondern auf andere Weise deformiert werden, wie dies an sich im Stand der Technik bekannt ist.

In der US 6 398 373 B1 ist ein Projektionsobjektiv für eine mikrolithographische Projektionsbelichtungsanlage beschrieben, bei dem ein Spiegel zur Korrektur von Abbildungsfehlern nur so verbogen werden kann, dass sich die Lage des Spiegels durch die Verbiegung nicht verändert. Bei einem Ausführungsbeispiel sind insgesamt 24 Aktuatoren vorgesehen, die entlang der Umfangs des Spiegels verteilt sind. Zur Vermeidung von Lageänderungen des Spiegels werden je nach gewünschter Verformung solche Aktuatoren angesteuert, deren Anordnung zueinander bestimmten Symmetriemustern entspricht.

### ZUSAMMENFASSUNG DER ERFINDUNG

Aufgabe der Erfindung ist es, ein Projektionsobjektiv einer mikrolithographischen Projektionsbelichtungsanlage anzugeben, bei dem derartige unerwünschte Beeinträchtigungen der Abbildung infolge gezielter Deformationen optischer Elemente weitgehend vermieden werden.

Diese Aufgabe wird durch ein Projektionsobjektiv mit mehreren optischen Elementen und mit mindestens einem Aktuator zum Ausüben einer mechanischen Kraft gelöst, durch die ein ausgewähltes optisches Element des Projektionsobjektivs deformierbar ist. Ferner weist das Projektionsobjektiv mindestens einen Manipulator auf, durch den die räumliche Lage eines der optischen Elemente veränderbar ist. Außerdem ist eine auf den mindestens einen Manipulator einwirkenden Regel- oder Steuereinrichtung zur Regelung beziehungsweise Steuerung der Lageveränderung des einen optischen Elements in Abhängigkeit von der durch den mindestens einen Aktuator ausgeübten Kraft vorgesehen.

Die Erfindung beruht auf der Erkenntnis, daß insbesondere dann, wenn das betreffende optische Element nur an relativ wenigen Punkten gelagert ist, wie dies etwa bei der isostatischen Lagerung der Fall ist, durch die Aktuatoren Kräfte hervorgerufen werden, die nicht nur zu einer Deformation, sondern auch zu einer Veränderung der räumlichen Lage des optischen Elements führen. Die Art der Lageveränderung hängt dabei insbesondere davon ab, an welchen Punkten das optische Element gehalten ist und wo die von den Aktuatoren erzeugten Kräfte an dem optischen Element angreifen. Bei einer isostatischen Lagerung des optischen Elements, bei der drei um 120° entlang des Umfangs versetzte Lagerungspunkte vorgesehen sind, kommt es beispielsweise zu einer Verkippung des optischen Elements um eine Querachse des optischen Elements, wenn dieses zur Astigmatismuskorrektur sattelartig verbogen wird. Bei anderen Konstellationen von Lagerungen des optischen Elements und daran angreifender Aktuatoren kann die Lageveränderung auch in einer translatorischen Verlagerung des optischen Elements in einer zur Symmetrieachse senkrechten Ebene bestehen.

Zu unerwünschten Lagerveränderungen infolge von Deformationen kann es jedoch selbst dann kommen, wenn das optische Element an sehr vielen Punkten gelagert ist. Ursache hierfür sind im allgemeinen Fertigungstoleranzen und montageinduzierte Asymmetrien.

Mit Hilfe des erfindungsgemäßen mindestens einen Manipulators können die vorstehend beschriebenen unerwünschten und zur Beeinträchtigung der Abbildungseigenschaften führenden Lageveränderungen des optischen Elements ausgeglichen werden. In den meisten Fällen wird hierzu ein einziger Manipulator nicht ausreichen, so daß mehrere Manipulatoren vorzusehen sind, deren Einwirken auf das optische Element entsprechend abgestimmt sein muß.

Vorzugsweise wirkt der mindestens eine Manipulator dabei auf das ausgewählte optische Element ein, bei dem die unerwünschte Lageveränderung infolge der Deformation aufgetreten ist. Es ist jedoch auch möglich, ein anderes als das deformierte optische Element mit Hilfe des mindestens einen Manipulators zu verkippen, zu verlagern oder in sonstiger Weise in seiner Lage zu verändern, um auf diese Weise die Wirkungen zu kompensieren, die durch die Lageveränderung des ausgewählten optischen Elements infolge der Deformation hervorgerufen werden.

Falls sowohl der mindestens eine Aktuator, mit dem das optische Element deformiert werden kann, als auch der mindestens eine Manipulator, mit dem die Lageveränderung herbeigeführt wird, fluidisch, d.h. hydraulisch oder pneumatisch, betätigbar sind, so ist es bevorzugt, wenn der mindestens eine Aktuator und der mindestens eine Manipulator derart an ein fluidisches Drucksystem angeschlossen sind, daß sie beide gleichzeitig fluidisch betätigbar sind. Gerade fluidische Drucksysteme bieten die Möglichkeit, Kräfte gleichzeitig an verschiedenen Orten innerhalb des Systems auftreten zu lassen.

Es kann zweckmäßig sein, die Entkopplung der Druckleitung von dem optischen Element dadurch zu verbessern, daß in einer Druckleitung mehrere elastische Ausgleichselemente integriert sind, die derart zueinander angeordnet sind, daß sich die bei einer Druckänderung darin ausbildenden Verformungskräfte zumindest weitgehend gegenseitig kompensieren. Verformungskräfte, die bei einer Druckänderung in einem Ausgleichselement wirken, können sich auf diese Weise nicht in unerwünschter Weise auf das optische Element übertragen. Diese kräftefreie Anbindung des optischen Elements an eine Versorgungseinrichtung des Drucksystems ist auch unabhängig von den erfindungsgemäßen Manipulatoren vorteilhaft einsetzbar.

Am einfachsten läßt sich eine solche Anordnung realisieren, wenn zwei gemeinsam mit einer Druckzuleitung und gemeinsam mit einer Druckableitung verbundene Ausgleichselemente diametral einander gegenüberliegend angeordnet sind. Bei einer solchen Anordnung wird lediglich ein zusätzliches Ausgleichselement benötigt.

Der mindestens eine Manipulator selbst kann unmittelbar an dem optischen Element oder aber über eine Fassung, in der das ausgewählte optische Element aufgenommen ist, an diesem angreifen. Greift der mindestens eine Manipulator an der Fassung an, so führt dies bei einer Betätigung des mindestens einen Manipulators zu einer Relativbewegung zwischen der Fassung und dem darin aufgenommenen optischen Element einerseits und einem Gehäuse des Objektivs andererseits.

Ist die Fassung ihrerseits in einem Rahmen gehaltert, der gegenüber dem Gehäuse des Objektivs festgelegt ist, so kann der mindestens eine Manipulator auch an einem solchen Rahmen angreifen. Auf diese Weise wird die Lagerung des optischen Elements in der Fassung nicht durch den mindestens einen Manipulator beeinflußt.

Anstelle eines fluidischen Drucksystems können der mindestens eine Aktuator und/oder der mindestens eine Manipulator selbstverständlich auch mit Hilfe anderer Stellelemente betätigt werden. Präzise einstellbare Kräfte können beispielsweise mit Hilfe piezoelektrischer Elemente ausgeübt werden.

Aufgabe der Erfindung ist es außerdem, ein verbessertes Verfahren zur Korrektur optischer Eigenschaften eines Projektionsobjektivs angegeben.

Diese Aufgabe wird durch ein Verfahren mit den Merkmalen des Anspruchs 13 gelöst.

### KURZE BESCHREIBUNG DER ZEICHUNGEN

Weitere Vorteile und Merkmale der Erfindung ergeben sich aus der nachfolgenden Beschreibung der Ausführungsbeispiele anhand der Zeichnungen. Darin zeigen:
- Figur 1: ein katadioptrisches Projektionsobjektiv einer mikrolithographischen Projektionsbelichtungsan- lage mit einer Spiegeleinheit in einem Meridio- nalschnitt;
- Figur 2: eine Seitenansicht der Spiegeleinheit für das in der Figur 1 gezeigte Projektionsobjektiv ge- mäß einem ersten Ausführungsbeispiel in einer vergrößerten, stark schematisierten Darstel- lung;
- Figur 3: einen Schnitt entlang der Linie III-III der in der Figur 2 gezeigten Spiegeleinheit;
- Figur 4: die in der Figur 2 gezeigte Spiegeleinheit, je- doch mit einer Verkippung infolge einer durch Aktuatoren erzeugten Verbiegung;
- Figur 5: die in der Figur 4 gezeigte Spiegeleinheit, bei der die Verkippung durch Manipulatoren rückgän- gig gemacht ist;
- Figur 6: eine Seitenansicht einer Spiegeleinheit für das in der Figur 1 gezeigte Projektionsobjektiv ge- mäß einem zweiten Ausführungsbeispiel in einer vergrößerten, stark schematisierten Darstel- lung;
- Figur 7: eine Seitenansicht einer Spiegeleinheit für das in der Figur 1 gezeigte Projektionsobjektiv ge- mäß einem dritten Ausführungsbeispiel in einer vergrößerten, stark schematisierten Darstel- lung;
- Figur 8: die in den Figuren 1 bis 5 gezeigte Spiegelein- heit mit einem Hydrauliksystem;
- Figur 9: die in den Figuren 1 bis 5 gezeigte Spiegelein- heit mit einem anderen Hydrauliksystem;
- Figur 10: die in den Figuren 1 bis 5 gezeigte Spiegelein- heit mit einem weiteren Hydrauliksystem im un- deformierten Zustand;
- Figur 11: die in der Figur 10 gezeigte Spiegeleinheit im deformierten Zustand mit Kippkorrektur;
- Figur 12: eine Ausgleichseinheit zur kräftefreien Anbin- dung einer Spiegeleinheit an ein Gehäuse über eine Druckleitung.

### BESCHREIBUNG BEVORZUGTER AUSFÜHRUNGSBEISPIELE

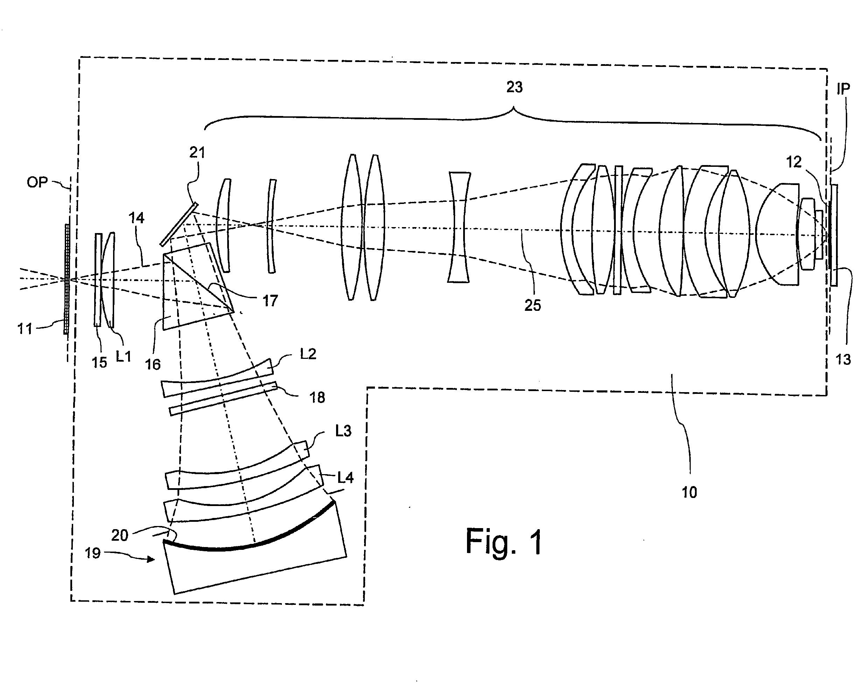

In der Figur 1 ist ein Projektionsobjektiv einer mikrolithographischen Projektionsbelichtungsanlage in einem Meridionalschnitt vereinfacht dargestellt und insgesamt mit 10 bezeichnet. Das Projektionsobjektiv, das auch in der PCT/EP03/04015 der Anmelderin beschrieben ist, dient dazu, in einem Retikel 11 enthaltene Strukturen verkleinert auf einer lichtempfindlichen Schicht 12 abzubilden, die aus einem Photolack besteht und auf einem Substrat 13 aufgebracht ist. Das Retikel 11 ist dabei in einer Objektebene OP und die lichtempfindliche Schicht 12 in einer Bildebene IP des Projektionsobjektivs 10 angeordnet.

In der Figur 1 gestrichelt angedeutetes Projektionslicht 14, das von einer Beleuchtungseinrichtung der Projektionsbelichtungsanlage erzeugt wird und bei dem dargestellten Ausführungsbeispiel eine Wellenlänge von 157 nm hat, gelangt nach Durchtritt durch das Retikel 11 über eine planparallele Platte 15 und eine Linse L1 in einen Strahlteilerwürfel 16. Dort wird das Projektionslicht 14 an einer darin enthaltenen polarisationsselektiven Strahlteilerschicht 17 reflektiert und über eine Linse L2, ein Viertelwellenlängenplättchen 18 und zwei weitere Linsen L3 und L4 auf eine Spiegeleinheit 19 mit einem sphärischen Spiegel 20 und einer noch näher zu erläuternden Fassung geworfen.

Nach Reflexion an dem sphärischen Spiegel 20 durchsetzt das Projektionslicht 14 erneut die Linsen L4 und L3, das Viertelwellenlängenplättchen 18 sowie die Linse L2 und fällt auf die polarisationsselektive Strahlteilerschicht 17. Dort wird das Projektionslicht 14 allerdings nicht reflektiert, sondern transmittiert, da die Polarisation des Projektionslichts 14 durch den zweimaligen Durchtritt durch das Viertelwellenlängenplättchen 18 um 90° gedreht wurde. Von dem Strahlteilerwürfel 16 gelangt das Projektionslicht 14 über einen Planspiegel 21 in einen rein dioptrischen Teil 23 des Projektionsobjektivs 10, in dem nicht näher bezeichnete refraktive optische Elemente entlang einer mit 25 angedeuteten optischen Achse angeordnet sind.

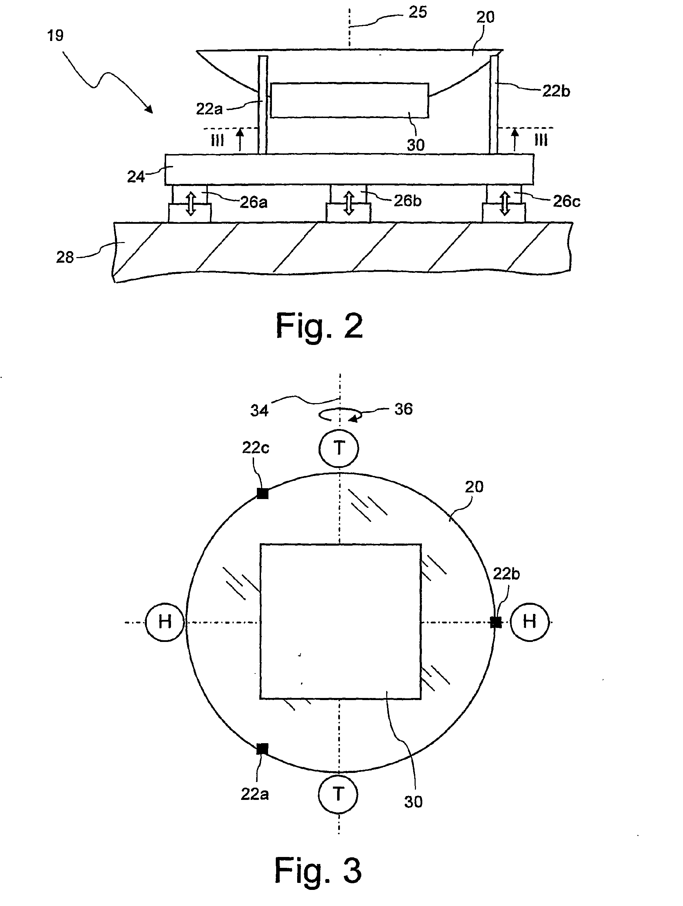

In den Figuren 2 und 3 ist die Spiegeleinheit 19 für das Projektionsobjektiv 10 gemäß einem ersten Ausführungsbeispiel stark schematisiert in einer Seitenansicht bzw. einem horizontalen Schnitt entlang der Linie III-III dargestellt. Der Spiegel 20 der Spiegeleinheit 19 ist in einer isostatischen Fassung aufgenommen, die durch drei Lagereinheiten 22a, 22b und 22c gebildet wird. Die Lagereinheiten 22a, 22b und 22c sind in Abständen von 120° über den Umfang des Spiegels 20 verteilt, wie dies in der Figur 3 erkennbar ist. Aufgrund der isostatischen Lagerung ist der Spiegel 20 steif und dennoch nahezu kräftefrei in der Fassung aufgenommen. Mögliche Ausbildungen für die Lagereinheiten 22a, 22b, 22c sind an sich im Stand der Technik bekannt, siehe z.B. die EP 1 245 982 A2, die der US 2002176094 A1 entspricht.

Die Lagereinheiten 22a, 22b, 22c sind an einem Rahmen 24 befestigt, der z.B. eine kreisförmige Grundform haben kann. Bei der hier beschriebenen isostatischen Lagerung kommt aber auch eine dreieckige Grundform in Betracht, wie dies ebenfalls aus der vorstehend erwähnten EP 1 245 982 A2 bekannt ist.

Der Rahmen 24 ist über drei Manipulatoren 26a, 26b und 26c, die an den Ecken eines gedachten gleichseitigen Dreiecks angeordnet sind, gegenüber einem Gehäuse 28 des Projektionsobjektivs 10 festgelegt. Die Manipulatoren 26a bis 26c umfassen bei dem dargestellten Ausführungsbeispiel jeweils zwei hydraulisch teleskopierbare Zylinder, wodurch die Länge der Manipulatoren 26a bis 26c hydraulisch veränderbar ist. Bei entsprechender Ansteuerung der Manipulatoren 26a bis 26c kann der Rahmen 24 gegenüber dem Gehäuse 28 um jede zur optischen Achse 25 des Projektionsobjektivs 10 senkrechte Achse verkippt werden.

An der Unterseite des Spiegels 20 ist eine insgesamt mit 30 bezeichnete Aktuatoreinheit angeordnet, mit der sich der Spiegel 20 verbiegen läßt. Die Aktuatoreinheit 30 umfaßt zu diesem Zweck mehrere nicht dargestellte, weil an sich bekannte Einzelaktuatoren, die um die optische Achse 25 herum angeordnet sind. Die Aktuatoreinheit 30 kann auch so ausgeführt sein, daß die Einzelaktuatoren vom Umfang her auf den Spiegel 20 einwirken. Mögliche Realisierungen für eine Aktuatoreinheit 30 mit mehreren Einzelaktuatoren sind der DE 198 59 634 A1 (entspricht US 6 307 688) und der DE 198 27 603 A1 (entspricht US 6 388 823) entnehmbar.

Im dargestellten Ausführungsbeispiel wird angenommen, daß sich mit Hilfe der Aktuatoreinheit 30 ein zweiwelliger Astigmatismus korrigieren läßt. Die in der Aktuatoreinheit 30 enthaltenen Einzelaktuatoren müssen zu diesem Zweck so an dem Spiegel 20 angreifen, daß aufgrund der dadurch erzeugten Biegemomente der Spiegel 20 sattelartig verbogen wird. In der Figur 3 ist diese sattelartige Verbiegung durch Kreise mit eingeschriebenen Großbuchstaben H und T angedeutet. Kreise mit einem eingeschriebenen Buchstabe H zeigen dabei Orte an dem Spiegel 20 an, die am höchsten in dem Sinne liegen, daß sie am weitesten von dem Rahmen 24 beabstandet sind. Kreise mit einem eingeschriebenen Buchstaben T zeigen Orte an, die am tiefsten liegen und somit den kleinsten Abstand zu dem Rahmen 24 aufweisen.

Um eine derartige sattelartige Verbiegung zu erzeugen, können die Einzelaktuatoren der Aktuatoreinheit 30 so angeordnet und betätigt werden, daß an zwei einander winkelmäßig um 180° gegenüberliegenden Punkten Druckkräfte in Richtung der optischen Achse 25 erzeugt werden, während entgegengesetzt gerichtete Kräfte an zwei hierzu winkelmäßig um jeweils 90° versetzten Punkten auf den Spiegel 20 einwirken.

Wie man leicht anhand der Figur 3 erkennen kann, führen derartige Kräfte bei der gezeigten isostatischen Lagerung zu einer Verkippung des Spiegels 20 um eine horizontale Achse 34, die durch die tiefer liegenden Punkte T verläuft. Die Richtung der Verkippung ist in der Figur 3 durch einen Pfeil 36 angedeutet. Ursache der Verkippung ist die Tatsache, daß sich die zweizählige Symmetrie der Kräfte nicht mit der dreizähligen Symmetrie der Lagerung in den Lagereinheiten 22a, 22b, 22c in Übereinstimmung bringen läßt. Bei einer Lagerung an vier geeignet gewählten Punkten würde diese Verkippung nicht auftreten. Eine Lagerung an vier Punkten ist jedoch bekanntlich im Vergleich zu einer isostatischen Lagerung in vieler Hinsicht nachteilig.

Die Verkippung um die Achse 34 wird durch die Lagereinheiten 22a bis 22c aufgenommen, die zu diesem Zweck elastische Eigenschaften aufweisen können, wie dies in der EP 1 245 982 A2 (entspricht US 2002176094 A1) beschrieben ist.

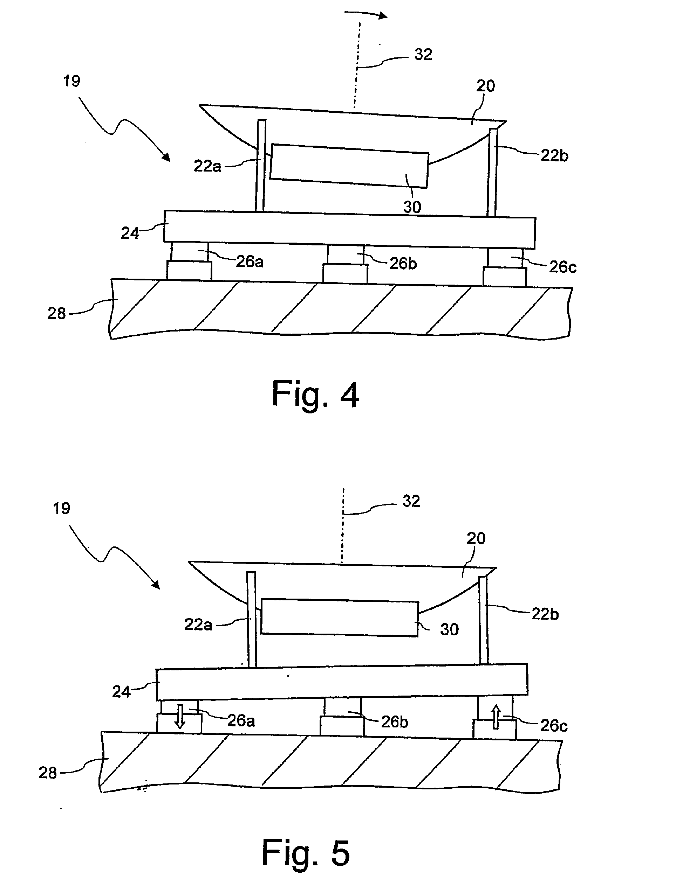

In der Figur 4 ist der Spiegel 20 in einer der Figur 2 entsprechenden Seitenansicht gezeigt, wobei jedoch aufgrund der sattelartigen Durchbiegung, die in der Figur 4 nicht erkennbar ist, der Spiegel 20 in der vorstehend beschriebenen Weise um die Achse 34 verkippt ist. Die Symmetrieachse 32 des Spiegels 20, die normalerweise mit der optischen Achse 25 des Projektionsobjektivs 10 zusammenfällt, ist infolge der Verkippung um den Kippwinkel gegenüber der ursprünglichen Sollage verstellt. Aus Gründen der Anschaulichkeit ist dieser Kippwinkel stark übertrieben dargestellt.

Die drei Manipulatoren 26a bis 26c werden nun so angesteuert, daß die verkippte Symmetrieachse 32 des Spiegels 20 wieder in ihre (in der Figur 4 senkrechte) Sollage zurückgeführt wird. Die Manipulatoren 26a und 26c, die außerhalb der Kippachse angeordnet sind, werden hierzu derart verstellt, daß der gesamte Rahmen 24 einschließlich der darauf befestigten Lagereinheiten 22a bis 22c und des darin aufgenommenen Spiegels 20 um den erforderlichen Ausgleichswinkel zurückgekippt wird. Betragsmäßig stimmt dieser Ausgleichswinkel mit dem Kippwinkel überein, um den der Spiegel 20 bei der Verbiegung gegenüber dem Rahmen 24 verkippt wird. Wie in der Figur 5 gut zu erkennen ist, steht aufgrund der durch die drei Manipulatoren 26a bis 26c erzeugten Ausgleichsverkippung die Symmetrieachse 32 des Spiegels 20 auch nach dessen Verbiegung in ihrer in der Figur 5 senkrecht nach oben weisenden Sollage. Die durch die Verbiegung erzeugte Verkippung des Spiegels 20 in den Lagereinheiten 22a bis 22c beeinträchtigt somit nicht die Abbildungseigenschaften des Spiegels 20.

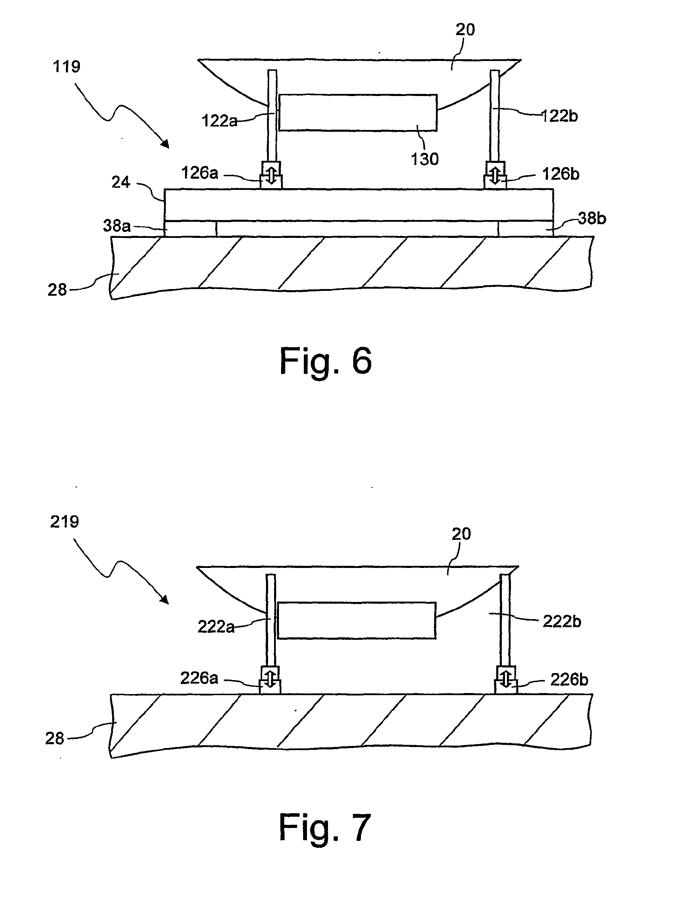

Die Figur 6 zeigt eine für das Projektionsobjektiv 10 geeignete Spiegeleinheit 119 gemäß einem zweiten Ausführungsbeispiel. Gleiche Teile wie bei dem vorstehend beschriebenen Ausführungsbeispiel sind dabei mit gleichen Bezugsziffern und einander entsprechende Teile mit um 100 erhöhten Bezugsziffern bezeichnet.

Bei der Spiegeleinheit 119 wird zum Ausgleich von durch Verbiegungen hervorgerufenen Kippbewegungen nicht der Rahmen 24, sondern allein der Spiegel 20 entsprechend verkippt. Zu diesem Zweck sind in zwei Lagereinheiten 122a, 122b sowie in eine in der Figur 6 durch die Lagereinheit 122a verdeckte dritte Lagereinheit jeweils ein Manipulator 126a bzw. 126b integriert, durch welche die Längen der drei Lagereinheiten verstellt werden können. Der Rahmen 24 hingegen ist fest mit dem Gehäuse 28 über Verbindungselemente 38a, 38b verbunden. Um eine Verkippung des Spiegels 20 rückgängig zu machen, wie sie in der Figur 4 für die Spiegeleinheit 19 dargestellt ist, müssen die Manipulatoren 126a und der dahinter liegende, in der Figur 6 nicht erkennbare Manipulator eingefahren werden und der Manipulator 126b ausgefahren werden, damit sich deren Länge verkleinert bzw. vergrößert.

Die Figur 7 zeigt eine für das Projektionsobjektiv 10 geeignete Spiegeleinheit 219 gemäß einem dritten Ausführungsbeispiel. Gleiche Teile wie bei der Spiegeleinheit 19 sind dabei mit gleichen Bezugsziffern und einander entsprechende Teile mit um 200 erhöhten Bezugsziffern bezeichnet.

Die in der Figur 7 dargestellte Spiegeleinheit 219 unterscheidet sich von der in der Figur 6 dargestellten Spiegeleinheit 119 lediglich dadurch, daß Lagereinheiten 222a, 222b über Manipulatoren 226a, 226b unmittelbar, d.h. ohne einen dazwischen liegenden Rahmen 24, an dem Gehäuse 28 des Projektionsobjektivs 10 befestigt sind.

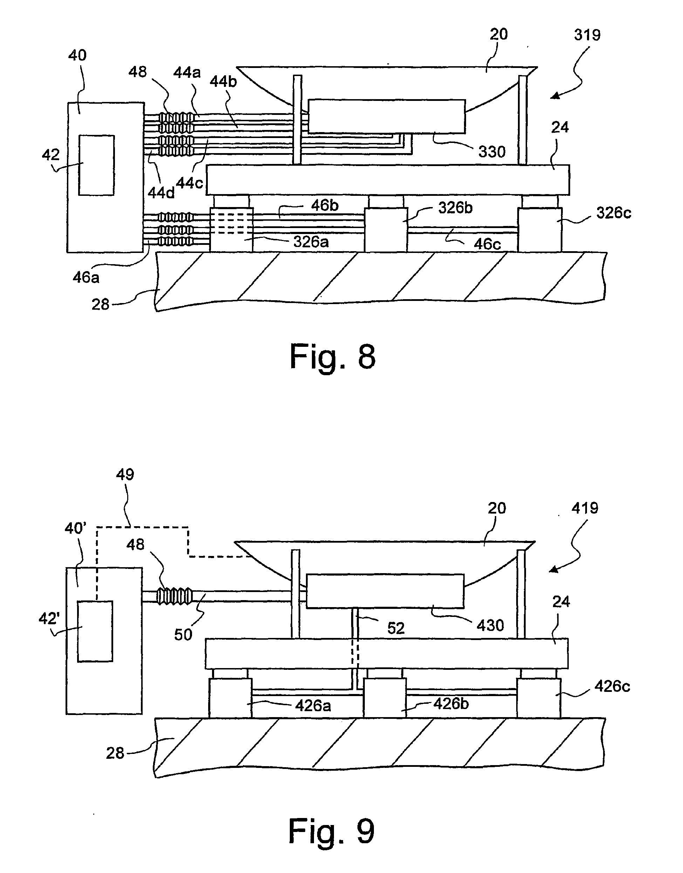

Die Figur 8 zeigt eine für das Projektionsobjektiv 10 geeignete Spiegeleinheit 319 gemäß einem vierten Ausführungsbeispiel. Gleiche Teile wie bei der Spiegeleinheit 19 sind mit gleichen Bezugsziffern und einander entsprechende Teile mit um 300 erhöhten Bezugsziffern bezeichnet.

Die Spiegeleinheit 319 entspricht im wesentlichen der Spiegeleinheit 19, wie sie in der Figur 2 dargestellt ist. Zusätzlich gezeigt ist eine Hydraulikeinrichtung 40 zur Versorgung einer Aktuatoreinheit 330 und von Manipulatoren 326a, 326b, 326c mit einer Hydraulikflüssigkeit.

Die Hydraulikeinrichtung 40 enthält eine Steuerung 42, die über Ventile in nicht näher dargestellter Weise den Druck der Hydraulikflüssigkeit steuert, die zur Betätigung der in der Aktuatoreinheit 30 enthaltenen Einzelaktuatoren und der Manipulatoren 26a, 26b, 26c dient. Bei der Spiegeleinheit 319 sind zu diesem Zweck die vier in der Aktuatoreinheit 30 enthaltenen Einzelaktuatoren über jeweils unabhängige erste Druckleitungen 44a bis 44d mit der Hydraulikeinrichtung 40 verbunden.

Die Hydraulikeinrichtung 40 ist außerdem über zweite Druckleitungen 46a, 46b und 46c mit den Manipulatoren 326a, 326b bzw. 326c verbunden. In jede der ersten und zweiten Druckleitungen 44a bis 44d bzw. 46a bis 46c ist dabei ein Ausgleichselement 48 in Form eines Faltenbalgs integriert. Das Ausgleichselement 48 hat die Aufgabe, die Hydraulikeinrichtung 40 so von der Aktuatoreinheit 330 und den Manipulatoren 326a bis 326c zu entkoppeln, daß sich Erschütterungen, die in der Hydraulikeinrichtung 40 durch darin enthaltene Ventile oder Pumpen oder durch das damit verbundene Gehäuse 28 des Projektionsobjektivs hervorgerufen werden, nicht über die ersten und zweiten Druckleitungen 44a bis 44d bzw. 46a bis 46c auf den Spiegel 20 übertragen können.

Die Steuerung 42 der Hydraulikeinrichtung 40 ist so ausgelegt, daß eine Betätigung der Aktuatoreinheit 330 mit einer synchronen Betätigung der Manipulatoren 326a bis 326c einhergeht. Die Steuerung 42 greift hierzu auf eine gespeicherte Tabelle zu, in der für eine Vielzahl von Stellungen der in der Aktuatoreinheit 330 enthaltenen Einzelaktuatoren die Stellwege der Manipulatoren 326a bis 326c abgelegt sind, die erforderlich sind, um die Verkippung des Spiegels 20 infolge der durch die Aktuatoreinheit 330 hervorgerufenen Verbiegung wieder rückgängig zu machen.

Die Figur 9 zeigt eine für das Projektionsobjektiv 10 geeignete Spiegeleinheit 419 gemäß einem fünften Ausführungsbeispiel. Gleiche Teile wie bei der Spiegeleinheit 19 sind mit gleichen Bezugsziffern und einander entsprechende Teile mit um 400 erhöhten Bezugsziffern bezeichnet.

Die Spiegeleinheit 419 unterscheidet sich von der in der Figur 8 gezeigten Spiegeleinheit 319 unter anderem dadurch, daß die Steuerung 42 durch einen Regler 42' ersetzt ist, der über eine gestrichelt angedeutete Leitung 49 mit Positionssensoren verbunden ist, die die räumliche Lage des Spiegels 20 erfassen. Außerdem führt von der Hydraulikeinrichtung 40' lediglich eine Druckleitung 50 zu der Aktuatoreinheit 430. Diese ist über eine weitere Druckleitung 52 in Reihe mit Manipulatoren 426a bis 426c geschaltet. Jede Druckveränderung in der Druckleitung 50 führt auf diese Weise zu einer entsprechenden Druckveränderung in der Aktuatoreinheit 430 und in den Manipulatoren 426a bis 426c. Über entsprechend voreingestellte Ventile, die den Einzelaktuatoren der Aktuatoreinheit 430 sowie den Manipulatoren 426a'bis 426c zugeordnet sind, läßt sich erreichen, daß sich lediglich durch die Veränderung des Drucks der Hydraulikflüssigkeit in der Druckleitung 50 die gewünschte Deformation des Spiegels 20 sowie gleichzeitig eine Verkippung des Rahmens 24 relativ zu dem Gehäuse 28 einstellt. Auf diese Weise sind zwar die Aktuatoreinheit 430 und die Manipulatoren 426a bis 426c nicht mehr unabhängig voneinander steuerbar, die Steuerung der Spiegeleinheit 419 wird auf diese Weise jedoch erheblich vereinfacht.

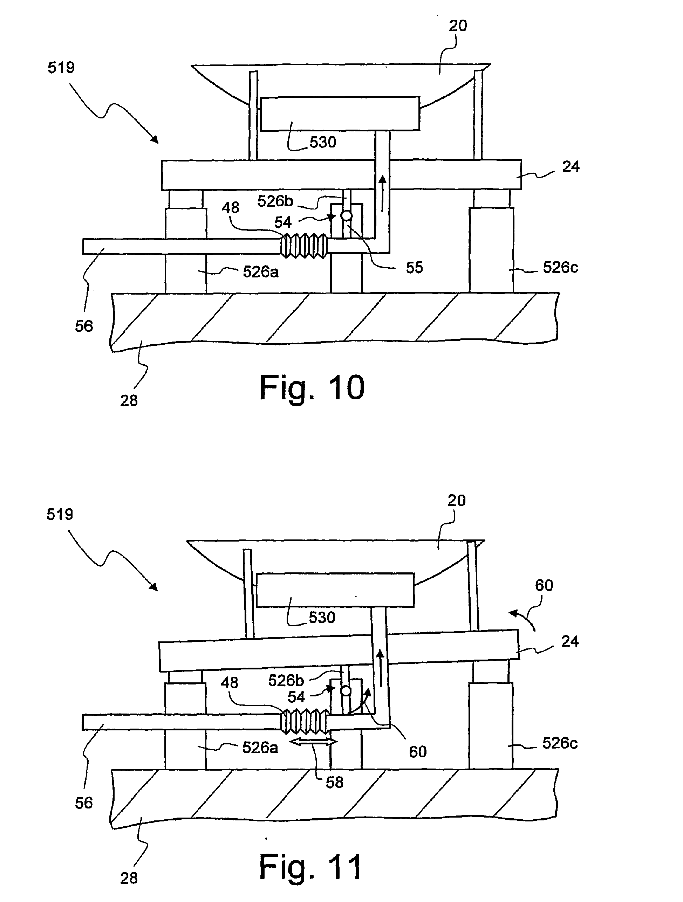

Die Figuren 10 und 11 zeigen eine für das Projektionsobjektiv 10 geeignete Spiegeleinheit 519 gemäß einem sechsten Ausführungsbeispiel mit unverbogenem Spiegel bzw. verbogenen Spiegel. Gleiche Teile wie bei der Spiegeleinheit 19 sind mit gleichen Bezugsziffern und einander entsprechende Teile mit um 500 erhöhten Bezugsziffern bezeichnet.

Bei der Spiegeleinheit 519 ist lediglich der Manipulator 526b aktiv ausgeführt. Die anderen beiden Manipulatoren 526a und 526c sind hingegen passiv ausgeführt sind. Dies bedeutet, daß die Manipulatoren 526a, 526c Längenänderungen lediglich passiv mitvollziehen können; eine aktive Längenänderung, z.B. durch Verändern eines anliegenden Hydraulikdrucks, ist nicht möglich.

Der aktive Manipulator 526b besteht im wesentlichen aus dem oberen Arm eines Hebelgetriebes 54, dessen unterer Arm 55 an eine Druckleitung 56 angekoppelt ist, welche eine Druckeinrichtung (nicht dargestellt) mit einer Aktuatoreinheit 530 verbindet.

Wird zur Betätigung der in der Aktuatoreinheit 530 enthaltenen Einzelaktuatoren der Druck der Hydraulikflüssigkeit in der Druckleitung 56 erhöht, so führt dies zu einer Verlängerung des elastischen Ausgleichselements 48, was in der Figur 11 durch einen Doppelpfeil 58 angedeutet ist. Über das Hebelgetriebe 54 übersetzt sich diese Längenänderung 58 in eine Kippbewegung des Rahmens 24 in der durch Pfeile 60 angegebenen Richtung. Auf diese Weise wird der Rahmen 24 ohne zusätzliche Steuerungs- oder Regelungseinrichtungen selbsttätig bei jeder Verbiegung des Spiegels 20 in der gewünschten Weise verkippt. Eine Abstimmung des Kippwinkels ist durch entsprechende Auslegung des Hebelgetriebes 54 ohne weiteres möglich.

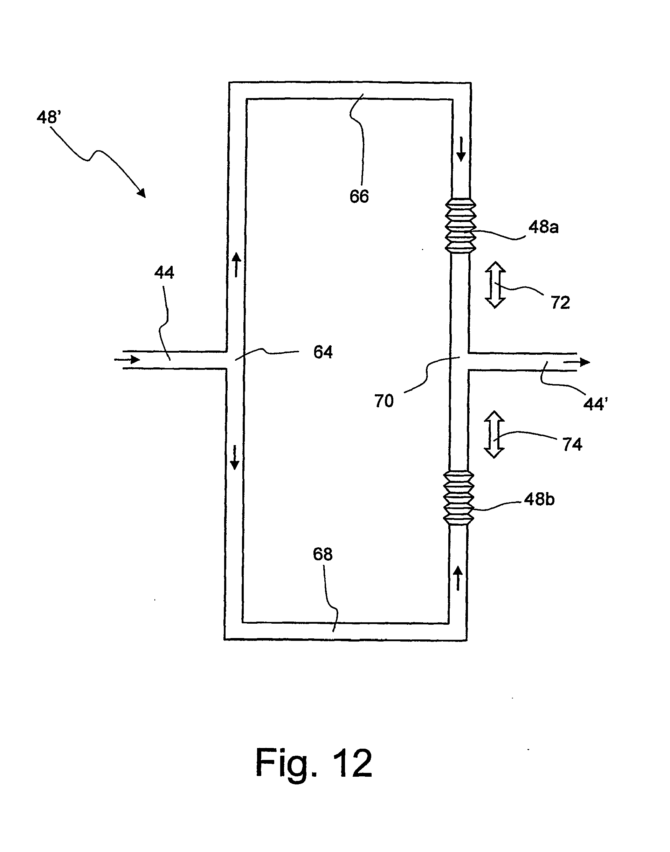

Falls die durch Manipulatoren erzeugte Kippbewegung unabhängig von der Aktuatoreinheit 30 steuerbar sein soll, wie dies bei der Spiegeleinheit 319 gemäß der Figur 8 der Fall ist, so ist es vorteilhaft, die Ausgleichselemente 48 in den ersten und zweiten Druckleitungen 44a bis 44d bzw. 46a bis 46c jeweils durch eine Ausgleichseinheit 48' zu ersetzen, wie sie in der Figur 12 dargestellt ist. Die Ausgleichseinheit 48' enthält ein erstes T-Stück 64, welches eine Druckleitung 44 in zwei parallele Druckleitungen 66, 68 aufteilt. In jeder der parallelen Druckleitungen 66, 68 ist jeweils ein Ausgleichselement 48a bzw. 48b integriert, und zwar so, daß sich die Ausgleichselemente 48a, 48b einander gegenüberliegen. Über eine zweites T-Stück 70 werden die parallelen Druckleitungen 66, 68 hinter den Ausgleichselementen 48a, 48b wieder zu einer Druckleitung 44' zusammengeführt.

Da die Ausgleichselemente 48a, 48b einander symmetrisch gegenüberliegen, führen Längenänderungen der Ausgleichselemente 48a, 48b, wie sie durch Doppelpfeile 72, 74 angedeutet sind, nicht zu einer Kraft in Längsrichtung von der von dem zweiten T-Stück 70 abgehenden Druckleitung 44'. Der zwischen den beiden Ausgleichselementen 48a, 48b liegende Abgriff durch das zweite T-Stück 70 bewirkt somit ein Kräftegleichgewicht, welches die Weiterleitung von unerwünschten Stellkräften über die Druckleitung 44' und eine Aktuatoreinheit und/oder einen Manipulator an den Spiegel 20 unterbindet.

## Patentansprüche

1. Projektionsobjektiv einer mikrolithographischen Projektionsbelichtungsanlage, mit:
a) mehreren optischen Elementen (15, 16, 18, 20, L1 bis L4),
b) mindestens einem Aktuator (30; 130; 330; 430; 530) zum Ausüben einer mechanischen Kraft, durch die ein ausgewähltes optisches Element (20) des Projektionsobjektivs (10) deformierbar ist,
c) mindestens einem Manipulator (26a, 26b, 26c; 126a, 126b; 226a, 226b; 326a, 326b, 326c; 426a, 426b, 426c; 526b), durch den die räumliche Lage eines der optischen Elemente (20) veränderbar ist, und mit
d) einer auf den mindestens einen Manipulator einwirkenden Regel- oder Steuereinrichtung (42'), die zur Regelung beziehungsweise Steuerung der Lageveränderung des einen optischen Elements (20) in Abhängigkeit von der durch den mindestens einen Aktuator (430; 330) ausgeübten Kraft eingerichtet ist.

2. Projektionsobjektiv nach Anspruch 1, wobei durch den mindestens einen Manipulator (26a, 26b, 26c; 126a, 126b; 226a, 226b; 326a, 326b, 326c; 426a, 426b, 426c; 526b) das eine optische Element (20) um eine zu einer Symmetrieachse (32) des optischen Elements (20) im wesentlichen senkrechte Achse (34) verkippbar ist.

3. Projektionsobjektiv nach Anspruch 1 oder 2, wobei durch den mindestens einen Manipulator das eine optische Element in einer Ebene senkrecht zu einer Symmetrieachse (32) des optischen Elements verlagerbar ist.

4. Projektionsobjektiv nach einem der vorhergehenden Ansprüche, wobei das eine optische Element, dessen räumliche Lage veränderbar ist, das ausgewählte optische Element (20) ist.

5. Projektionsobjektiv nach einem der vorhergehenden Ansprüche, wobei der mindestens eine Aktuator (30; 130; 330; 430; 530) fluidisch betätigbar ist.

6. Projektionsobjektiv nach einem der vorhergehenden Ansprüche, wobei der mindestens eine Manipulator (26a, 26b, 26c; 126a, 126b; 226a, 226b; 326a, 326b, 326c; 426a, 426b, 426c; 526b) fluidisch betätigbar ist.

7. Projektionsobjektiv nach den Ansprüchen 5 und 6, wobei der mindestens eine Aktuator (30; 130; 330; 430; 530) und der mindestens eine Manipulator (26a, 26b, 26c; 126a, 126b; 226a, 226b; 326a, 326b, 326c; 426a, 426b, 426c; 526b) derart an ein fluidisches Drucksystem (40; 40') angeschlossen sind, daß sie beide gleichzeitig fluidisch betätigbar sind.

8. Projektionsobjektiv nach einem der vorhergehenden Ansprüche, wobei der mindestens eine Manipulator unmittelbar an dem optischen Element angreift.

9. Projektionsobjektiv nach einem der Ansprüche 1 bis 7, wobei der mindestens eine Manipulator (126a, 126b; 226a, 226b) an einer Fassung (122a, 122b; 222a, 222b) angreift, in der das eine optische Element (20) aufgenommen ist.

10. Projektionsobjektiv nach einem der Ansprüche 1 bis 7, wobei der mindestens eine Manipulator (26a, 26b, 26c; 426a, 426b, 426c; 526, 526b, 526c) an einem Rahmen (24) angreift, an dem eine Fassung (22a, 22b, 22c) gehaltert ist, in der das eine optische Element (20) aufgenommen ist.

11. Projektionsobjektiv nach Anspruch 5 oder 6, wobei in einer Druckleitung (44) mehrere elastische Ausgleichselemente (48a, 48b) integriert sind, die derart zueinander angeordnet sind, daß sich die bei einer Druckänderung darin ausbildenden Verformungskräfte zumindest weitgehend gegenseitig kompensieren.

12. Projektionsobjektiv nach Anspruch 11, wobei zwei gemeinsam mit einer Druckzuleitung (44) und gemeinsam mit einer Druckableitung (44') verbundene Ausgleichselemente (48a, 48b) diametral einander gegenüberliegend angeordnet sind.

13. Verfahren zur Korrektur optischer Eigenschaften eines Projektionsobjektivs (10) einer mikrolithographischen Projektionsbelichtungsanlage, das mehrere optische Elemente (15, 16, 18, 20, L1 bis L4) und mindestens einen Aktuator (30; 130; 330; 430; 530) aufweist, durch die ein ausgewähltes optisches Element (20) des Projektionsobjektivs (10) deformierbar ist,
**dadurch gekennzeichnet, daß**
die räumliche Lage eines der optischen Elemente (20) in Abhängigkeit von einer durch den mindestens einen Aktuator (30; 130; 330; 430; 530) ausgeübten Kraft verändert wird.

## Claims

1. Projection objective of a microlithographic projection exposure apparatus, comprising
a) a plurality of optical elements (15, 16, 18, 20, L1 to L4),
b) at least one actuator (30; 130; 330; 430; 530) for exerting a mechanical force by which a selected optical element (20) of the projection objective (10) can be deformed,
c) at least one manipulator (26a, 26b, 26c; 126a, 126b; 226a, 226b; 326a, 326b, 326c; 426a, 426b, 426c; 526b) by which the spatial position of one of the optical elements (20) can be modified, and
d) a regulator or a controller (42') acting on the at least one manipulator, which is configured to regulate or control, respectively, the position change of the one optical element (20) as a function of the force exerted by the at least one actuator (430; 330).

2. Projection objective according to Claim 1, wherein the one optical element (20) can be tilted about an axis (34) substantially perpendicular to a symmetry axis (32) of the optical element (20) by the at least one manipulator (26a, 26b, 26c; 126a, 126b; 226a, 226b; 326a, 326b, 326c; 426a, 426b, 426c; 526b).

3. Projection objective according to Claim 1 or 2, wherein the one optical element can be displaced in a plane perpendicular to a symmetry axis (32) of the optical element by the at least one manipulator.

4. Projection objective according to one of the preceding claims, wherein the one optical element whose spatial position can be modified is the selected optical element (20).

5. Projection objective according to one of the preceding claims, wherein the at least one actuator (30; 130; 330; 430; 530) can be fluidically actuated.

6. Projection objective according to one of the preceding claims, wherein the at least one manipulator (26a, 26b, 26c; 126a, 126b; 226a, 226b; 326a, 326b, 326c; 426a, 426b, 426c; 526b) can be fluidically actuated.

7. Projection objective according to Claims 5 and 6, wherein the at least one actuator (30; 130; 330; 430; 530) and the at least one manipulator (26a, 26b, 26c; 126a, 126b; 226a, 226b; 326a, 326b, 326c; 426a, 426b, 426c; 526b) are connected to a fluidic pressure system (40; 40') so that they can both be fluidically actuated simultaneously.

8. Projection objective according to one of the preceding claims, wherein the at least one manipulator engages directly on the optical element.

9. Projection objective according to one of Claims 1 to 7, wherein the at least one manipulator (126a, 126b; 226a, 226b) engages on a mount (122a, 122b; 222a, 222b) in which the one optical element (20) is received.

10. Projection objective according to one of Claims 1 to 7, wherein the at least one manipulator (26a, 26b, 26c; 426a, 426b, 426c; 526, 526b, 526c) engages on a frame (24) on which a mount (22a, 22b, 22c), in which the one optical element (20) is received, is supported.

11. Projection objective according to Claim 5 or 6, wherein a plurality of resilient compensating elements (48a, 48b) are integrated in a pressure line (44), and are arranged relative to one another so that the deformation forces formed therein in the event of a pressure change mutually compensate at least substantially.

12. Projection objective according to Claim 11, wherein two compensating elements (48a, 48b) connected together to a pressure feed line (44) and together to a pressure discharge line (44') are arranged lying diametrically opposite each other.

13. Method for correcting optical properties of a projection objective (10) of a microlithographic projection exposure apparatus, which comprises a plurality of optical elements (15, 16, 18, 20, L1 to L4) and at least one actuator (30; 130; 330; 430; 530) by which a selected optical element (20) of the projection objective (10) can be deformed,
**characterised in that**
the spatial position of one of the optical elements (20) is modified as a function of a force exerted by the at least one actuator (30; 130; 330; 430; 530).

## Revendications

1. Objectif de projection d'un système d'exposition par projection microlithographique, comprenant :
a) plusieurs éléments optiques (15, 16, 18, 20, L1 à L4),
b) au moins un actionneur (30 ; 130 ; 330 ; 430 ; 530) pour exercer une force mécanique qui permet de déformer un élément optique sélectionné (20) de l'objectif de projection (10),
c) au moins un manipulateur (26a, 26b, 26c ; 126a, 126b ; 226a, 226b ; 326a, 326b, 326c; 426a, 426b, 426c; 526b) qui permet de modifier la position spatiale d'un des éléments optiques (20), et
d) un dispositif de régulation ou de commande (42') agissant sur ledit au moins un manipulateur, qui est conçu pour réguler ou commander la modification de position dudit un élément optique (20) en fonction de la force exercée par ledit au moins un actionneur (430 ; 330).

2. Objectif de projection selon la revendication 1, dans lequel ledit un élément optique (20) peut être basculé par ledit au moins un manipulateur (26a, 26b, 26c ; 126a, 126b ; 226a, 226b ; 326a, 326b, 326c; 426a, 426b, 426c ; 526b) autour d'un axe (34) essentiellement perpendiculaire à un axe de symétrie (32) de l'élément optique (20).

3. Objectif de projection selon la revendication 1 ou 2, dans lequel ledit un élément optique peut être déplacé par ledit au moins un manipulateur dans un plan perpendiculaire à un axe de symétrie (32) de l'élément optique.

4. Objectif de projection selon une des revendications précédentes, dans lequel ledit un élément optique dont la position spatiale peut être modifiée est l'élément optique sélectionné (20).

5. Objectif de projection selon une des revendications précédentes, dans lequel ledit au moins un actionneur (30; 130; 330 ; 430 ; 530) peut être actionné au moyen d'un fluide.

6. Objectif de projection selon une des revendications précédentes, dans lequel ledit au moins un manipulateur (26a, 26b, 26c ; 126a, 126b ; 226a, 226b ; 326a, 326b, 326c ; 426a, 426b, 426c ; 526b) peut être actionné au moyen d'un fluide.

7. Objectif de projection selon les revendications 5 et 6, dans lequel ledit au moins un actionneur (30 ; 130 ; 330 ; 430 ; 530) et lequel ledit au moins un manipulateur (26a, 26b, 26c ; 126a, 126b ; 226a, 226b ; 326a, 326b, 326c; 426a, 426b, 426c; 526b) sont raccordés à un système de pression fluidique (40 ; 40') de manière à pouvoir être tous deux actionnés en même temps au moyen d'un fluide.

8. Objectif de projection selon une des revendications précédentes, dans lequel ledit au moins un manipulateur agit directement sur l'élément optique.

9. Objectif de projection selon une des revendications 1 à 7, dans lequel ledit au moins un manipulateur (126a, 126b ; 226a, 226b) agit sur une monture (122a, 122b ; 222a, 222b) dans laquelle ledit un élément optique (20) est logé.

10. Objectif de projection selon une des revendications 1 à 7, dans lequel ledit au moins un manipulateur (26a, 26b, 26c ; 426a, 426b, 426c; 526, 526b, 526c) agit sur un cadre (24) auquel est fixée une monture (22a, 22b, 22c) dans laquelle ledit un élément optique (20) est logé.

11. Objectif de projection selon la revendication 5 ou 6, dans lequel plusieurs éléments de compensation élastiques (48a, 48b) sont intégrés dans une conduite sous pression (44) et disposés les uns par rapport aux autres de façon que les forces de déformation qui s'y développent lors d'une variation de pression se compensent mutuellement au moins en grande partie.

12. Objectif de projection selon la revendication 11, dans lequel deux éléments de compensation (48a, 48b) reliés en commun à une conduite d'amenée de pression (44) et en commun à une conduite d'évacuation de pression (44') sont disposés de manière diamétralement opposée.

13. Procédé de correction des propriétés optiques d'un objectif de projection (10) d'un système d'exposition par projection microlithographique qui présente plusieurs éléments optiques (15, 16, 18, 20, L1 à L4) et au moins un actionneur (30 ; 130 ; 330 ; 430 ; 530) qui permet de déformer un élément optique sélectionné (20) de l'objectif de projection (10),
**caractérisé en ce que**
la position spatiale d'un des éléments optiques (20) est modifiée en fonction d'une force exercée par ledit au moins actionneur (30 ; 130 ; 330 ; 430 ; 530).
